(19) Europäisches Patentamt
European Patent Office
Office européen des brevets

(11) **EP 2 372 799 A2**

(12) **EUROPEAN PATENT APPLICATION**

(43) Date of publication:
**05.10.2011 Bulletin 2011/40**

(51) Int Cl.:
**H01L 33/60** *(2010.01)*

(21) Application number: **11160120.9**

(22) Date of filing: **29.03.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.03.2010 JP 2010078456**
**27.05.2010 JP 2010121097**
**04.02.2011 JP 2011022376**

(71) Applicant: **Panasonic Corporation**
**Kadoma-shi**
**Osaka 571-8501 (JP)**

(72) Inventors:
• **Arita, Masaaki**
 **Fukuoka Fukuoka 812-8531 (JP)**
• **Giyoutoku, Akira**
 **Fukuoka Fukuoka 812-8531 (JP)**
• **Morimoto, Shinji**
 **Fukuoka Fukuoka 812-8531 (JP)**

(74) Representative: **Ehlers, Jochen**
**Eisenführ, Speiser & Partner**
**Johannes-Brahms-Platz 1**
**20355 Hamburg (DE)**

(54) **Highly reflective white material and led package**

(57)     An object of the invention is providing a highly reflective white material and an LED package capable of reflecting light having a peak at a wavelength of 350 nm through 800 nm with high efficiency.

In order to achieve the object, a highly reflective white material of the invention includes a mixed resin of an adamantane resin having an acrylic functional group and a silicone resin; and a curative agent. Thus, the white reflective material is less degraded through UV irradiation and exhibits high reflectance in a low wavelength region.

*FIG. 1*

EP 2 372 799 A2

**Description**

## BACKGROUND

1. Field of the invention

The present invention relates to a reflective material for taking out light with a peak at a specific wavelength with high efficiency. More particularly, it relates to a highly reflective white material and an LED package capable of reflecting light with a peak at a wavelength of 350 nm through 800 nm with high efficiency.

2. Description of the Related Art

Recently, for downsizing of a device or downsizing of a light source, use of a semiconductor light source, namely, a device utilizing a semiconductor laser or a light emitting diode (hereinafter referred to as an LED), has been proposed. Actually, features of an LED such as a long life, power saving, temperature stability and low voltage driving are evaluated, and hence an LED is now used in a display, a destination label, a vehicle lighting, a traffic light, a video camera and the like. Under these circumstances, it is necessary to improve the reflectance of a reflective material in order to take out light with a peak in a specific wavelength region with high efficiency by improving the luminous efficacy of light emitted from a light source of an LED.

As a reflective material to be used in an LED or the like, a reflective material made of an aromatic polyester resin has been disclosed. Such a reflective material has, however, a problem that it is degraded and yellowed and hence the reflectance is lowered with time when it is exposed to UV because an aromatic ring included in a molecular chain of such a reflective material absorbs UV. Furthermore, a resin composition obtained by adding titanium oxide to a polyamide-based resin has been disclosed as a reflective material (JP02-A-288274). Although this material exhibits very high reflectance in a visible light region, since titanium oxide well absorbs UV of a wavelength of 400 nm or lower, this material has a problem that it minimally reflects UV of a wavelength of 400 nm or lower.

## SUMMARY

An object of the invention is providing a highly reflective white material and an LED package capable of reflecting light with a peak at a wavelength of 350 m through 800 nm with high efficiency.

In order to achieve the object, a highly reflective white material of the present invention is obtained by curing a resin composition including a mixed resin of an adamantane resin having an acrylic functional group and a silicone resin, and a curative agent. The thus obtained white reflective material is minimally degraded by UV and exhibits high reflectance in a low wavelength region.

Another object of the invention is whitening a resin composition by causing a radical polymerization reaction through irradiation with light in a mixture of an adamantane resin having an acrylic functional group, a silicone resin and a curative agent in a prescribed ratio, and completing curing by further heating the resin composition.

Still another object of the invention is whitening a resin composition by causing radical polymerization of an adamantane resin having an acrylic functional group and a silicone resin. In other words, when an adamantane resin in which an epoxy group or the like is substituted, a resultant resin cannot be whitened.

Still another object of the invention is whitening a resin composition by causing a radical polymerization reaction through irradiation with light in a mixture of an adamantane resin having an acrylic functional group, a silicone resin, a curative agent and a filler in a prescribed ratio and completing curing by further heating the resin composition. Since the filler is used together, the reflectance is improved as well as the heat resistance is improved.

## BRIEF DESCRIPTION OF DRAWINGS

FIG. 1 is a process flow diagram employed for producing a reflective material of the invention.

FIG. 2 is a cross-sectional view illustrating an example of an LED package using a highly reflective white material according to Embodiment 1 of the invention.

FIG. 3 is a cross-sectional view illustrating another example of the LED package using the highly reflective white material of Embodiment 1 of the invention.

FIG. 4 is a cross-sectional view illustrating an example of an LED package using a highly reflective white material according to Embodiment 2 of the invention.

FIG. 5 is a cross-sectional view illustrating another example of the LED package using the highly reflective white material of Embodiment 2 of the invention.

FIG. 6 is a cross-sectional view illustrating an example of an LED package using a highly reflective white material according to Embodiment 3 of the invention.

FIG. 7 is a cross-sectional view illustrating another example of the LED package using the highly reflective white material of Embodiment 3 of the invention.

FIG. 8 is a cross-sectional view illustrating another example of the LED package using the highly reflective white material of Embodiment 3 of the invention.

FIG. 9 is a cross-sectional view illustrating another example of the LED package using the highly reflective white material of Embodiment 3 of the invention.

FIG. 10 is a diagram of Arrhenius plot employed for estimating a temperature for guaranteeing a 40000-hour operation of the highly reflective white material of the invention.

## DETAILED DESCRIPTION

### (EMBODIMENT 1)

An embodiment of the invention will now be described in detail. This embodiment describes a highly reflective white material obtained through primary curing performed by irradiating, with light, a resin composition for a reflective material containing a mixed resin, which includes, as 100 parts by weight in total, 20 through 90 parts by weight of an adamantane resin having an acrylic functional group and 10 through 80 parts by weight of a silicone resin, and a curative agent (which resin composition is described in claims 1 through 6) and through secondary curing performed by further heating the resulting resin composition.

Since the adamantane resin having an acrylic functional group, the silicone resin and the curative agent are mixed in a prescribed ratio and a radical polymerization reaction is caused through the irradiation with light, the resin composition is whitened, and the curing is completed by further heating the resin composition.

The adamantane resin having an acrylic functional group used in the highly reflective white material is preferably 1-adamantyl methacrylate.

Adamantane has a basket-shaped molecule in which 10 carbons are arranged in the same manner as in the structure of diamond. Hydrogen protrudes beyond the outside of the molecule, and an acrylic group is substituted for this hydrogen in the adamantane resin having an acrylic functional group. Examples of an acrylic adamantane resin are 1-admantyl acrylate, 1-adamantyl methacrylate, 1,3-adamantane dimethanol diacrylate and 1,3-adamantane dimethanol dimethacrylate. Among these resins, those apart from 1-adamantyl methacrylate are not preferably used because they are solids at room temperature, and although some of them may be used after liquefied through moistening with a hot water bath, they are crystallized again when the temperature is lowered to room temperature and hence are poor at compatibility with the silicone resin. When the adamantane resin having an acrylic functional group and the silicone resin are radically polymerized, the resultant resin composition is whitened, but this whitening function cannot be exhibited in using an adamantane resin in which an epoxy group or the like is substituted.

The silicone resin used in the highly reflective white material is preferably additional reaction type silicone rubber.

A silicone resin has a skeleton of a siloxane bond composed of silicon and oxygen, and in the additional reaction type silicone rubber, an organic group including a methyl group as a main body is bonded to the silicon. The silicone rubber is not particularly specified as far as it has siloxane with an organic group bonded as a basic skeleton, and for example, commercially available products of KE series of Shin-Etsu Silicones Co., Ltd. and IVS series of Momentive Performance Materials Japan may be used. When the adamantane resin having an acrylic functional group and the silicone resin are radically polymerized, the resultant resin composition may be whitened.

The curative agent used in the highly reflective white material is preferably a radical photopolymerization initiator.

As the curative agent, a radical polymerization initiator capable of generating radicals may be used. Examples of a radical photopolymerization initiator are alkylphenone-based initiators and acylphosphine oxide-based initiators, and commercially avaialbe products such as IRGACURE series and DAROCURE series of Ciba Japan may be used, among which IRGACURE184 and DAROCURE1173 of non-yellowing type are preferably used. An example of a radical thermopolymerization initiator is an organic peroxide-based radical polymerization initiator. Although a highly reflective white material may be obtained by using any of such initiators, they are not suitable for use in a reflective material having large thermal shrinkage and requiring moldability. In the reaction of this invention, radicals are generated for exhibiting the whitening function, and therefore, other cationic or anionic polymerization initiators are not suitably used.

Now, examples of the present invention will be described with reference to the accompanying drawings.

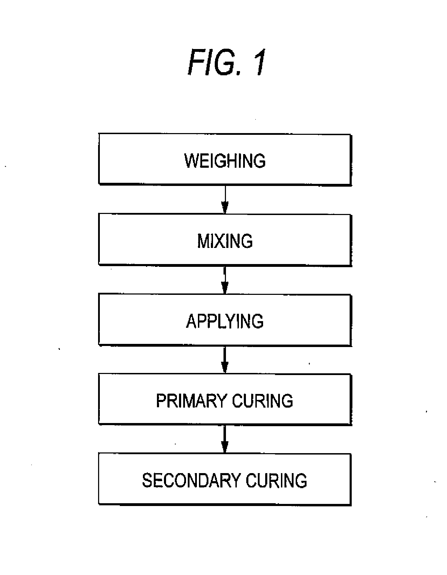

FIG. 1 is a process flow diagram illustrating fabrication process for a highly reflective white material according to this embodiment.

First, respective components weighed by a prescribed amount are put in a mixing vessel. Subsequently, the vessel is set in a stirring mixer having a degassing function under reduced pressure, so as to mix the components for a prescribed time. Then, a lead frame and a reflector are set in prescribed positions in a mold made of Teflon (registered trademark), and a resin composition for a reflective material mixed as described above is poured into the mold. Thereafter, the resin composition is irradiated with a prescribed quantity of UV for performing primary curing. Ultimately, the resultant resin composition is placed in an electric furnace heated at a prescribed temperature for performing secondary curing.

Thus, the resin composition may be homogeneously mixed. Furthermore, since the first curing with UV may be performed immediately after poring the resin composition into the mold made of Teflon (registered trademark) in which the lead frame and the reflector are set in the prescribed positions, leakage of the resin composition may be avoided.

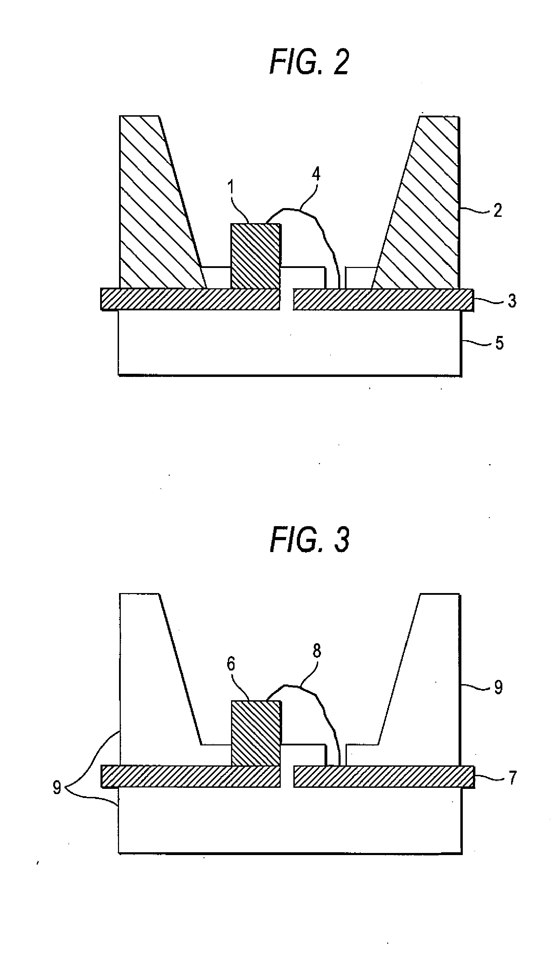

FIG. 2 is a cross-sectional view of an LED package in which a light emitting device 1, a reflector 2 and a lead frame 3 are molded with a highly reflective white material 5 with one end of the light emitting device 1 and one end of the lead frame 3 bonded to each other through a wire 4.

When this structure is employed, the lead frame 3 and the reflector 2 may be simultaneously adhered in molding them, and hence, a dedicated adhesive for adhering the reflector 2 and the lead frame 3 may be omitted. Furthermore, since the highly reflective white material 5 is applied also on the lead frame 3, there is no need to plate the lead frame with a highly reflective material such as silver.

FIG. 3 is a cross-sectional view of an LED package in which a light emitting device 6 and a lead frame 7 bonded to each other through a wire 8 are molded with a highly reflective white material 9 with a reflector 2 also made of the highly reflective white material 9.

When this structure is employed, the reflector may be formed by using the highly reflective white material 9, and hence, the fabrication process may be shortened.

Now, the present invention will be specifically described, and it is noted that the present invention is not limited to examples mentioned below.

(Example 1)

Twenty parts by weight of Adamantate X-M-104 (manufactured by IDEMITSU KOSAN Co., Ltd.), 40 parts by weight each of silicone resins KE1 09A and KE109B (manufactured by Shin-Etsu Silicones Co., Ltd.) and 0.005 part by weight of IRGACURE184 (manufactured by Ciba Japan) were put in a dedicated vessel for a rotation/revolution type degassing mixer and were stirred with a rotation/revolution type degassing mixer V-mini300 (manufactured by EME Corporation) at a revolution speed of 1600 rpm and a rotation speed of 800 rpm for 4 minutes. The thus obtained resin composition was filled in a syringe while stirring at a revolution speed of 1000 rpm and a rotation speed of 500 rpm for 30 seconds with the mixer V-mini300. Next, a mold was prepared by cutting a hole with a diameter of 30 mm at the center of a Teflon (registered trademark) sheet of 40 mm square with a thickness of 1 mm, and this mold was sandwiched between glass plates of 40 mm square with a thickness of 3 mm with a Teflon (registered trademark) sheet of 40 mm square with a thickness of 0.3 mm disposed therebetween. The mixed resin composition was filled in this mold. Both faces of the mold filled with the resin composition were irradiated with UV of 2500 mJ/cm$^2$ by using a belt conveyor type UV irradiation unit VB-15201 BY (manufactured by Ushio Inc.), so as to perform the primary curing. Thereafter, the mold was placed in a high temperature chamber ST-120 (manufactured by Espec Corp.), so as to perform the secondary curing at 150°C for 30 minutes.

(Example 2)

The fabrication process was carried out in the same manner as in Example 1 except that 40 parts by weight of Adamantate X-M-104 (manufactured by IDEMITSU KOSAN Co., Ltd.) and 30 parts by weight each of silicone resins KE109A and KE109B (manufactured by Shin-Etsu Silicones Co., Ltd.) were used.

(Example 3)

The fabrication process was carried out in the same manner as in Example 1 except that 50 parts by weight of Adamantate X-M-104 (manufactured by IDEMITSU KOSAN Co., Ltd.) and 25 parts by weight each of silicone resins KE109A and KE109B (manufactured by Shin-Etsu Silicones Co., Ltd.) were used.

(Example 4)

The fabrication process was carried out in the same manner as in Example 1 except that 60 parts by weight of Adamantate X-M-104 (manufactured by IDEMITSU KOSAN Co., Ltd.) and 20 parts by weight each of silicone resins KE109A and KE109B (manufactured by Shin-Etsu Silicones Co., Ltd.) were used.

(Example 5)

The fabrication process was carried out in the same manner as in Example 1 except that 80 parts by weight of Adamantate X-M-104 (manufactured by IDEMITSU KOSAN Co., Ltd.) and 10 parts by weight each of silicone resins KE109A and KE109B (manufactured by Shin-Etsu Silicones Co., Ltd.) were used.

(Example 6)

The fabrication process was carried out in the same manner as in Example 1 except that 90 parts by weight of Adamantate X-M-104 (manufactured by IDEMITSU KOSAN Co., Ltd.) and 5 parts by weight each of silicone resins KE109A and KE109B (manufactured by Shin-Etsu Silicones Co., Ltd.) were used.

(Comparative Example 1)

The fabrication process was carried out in the same manner as in Example 1 except that 10 parts by weight of Adamantate X-M-104 (manufactured by IDEMITSU KOSAN Co., Ltd.) and 45 parts by weight each of silicone resins KE109A and KE109B (manufactured by Shin-Etsu Silicones Co., Ltd.) were used.

(Comparative Example 2)

Fifty parts by weight each of silicone resins KE109A and KE109B (manufactured by Shin-Etsu Silicones Co., Ltd.) were put in a dedicated vessel for a rotation/revolution type degassing mixer and were stirred with a rotation/revolution type degassing mixer V-mini300 (manufactured by EME corporation) at a revolution speed of 1600 rpm and a rotation speed of 800 rpm for 4 minutes. The resultant resin composition was filled in a syringe while stirring at a revolution speed of 1000 rpm and a rotation speed of 500 rpm for 30 seconds with the mixer V-mini300. Next, a mold was prepared by cutting a hole with a diameter of 30 mm at the center of a Teflon (registered trademark) sheet of 40 mm square with a thickness of 1 mm, and this mold was sandwiched between glass plates of 40 mm square with a thickness of 3 mm with a Teflon (registered trademark) sheet of 40 mm square with a thickness of 0.3 mm disposed therebetween. The mixed resin composition was filled in this mold. Thereafter, the mold filled with the resin composition was placed in a high temperature chamber ST-120 (manufactured by Espec Corp.), so as to perform curing at 150°C for 30 minutes.

(Comparative Example 3)

Hundred parts by weight of Adamantate X-M-1 04 (manufactured by IDEMITSU KOSAN Co., Ltd.) and 0.005 part by weight of IRGACURE184 (manufactured by Ciba Japan) were put in a dedicated vessel for a rotation/revolution type degassing mixer and were stirred with a rotation/revolution type degassing mixer V-mini300 (manufactured by EME corporation) at a revolution speed of 1600 rpm and a rotation speed of 800 rpm for 4 minutes. The resultant resin composition was filled in a syringe while stirring at a revolution speed of 1000 rpm and a rotation speed of 500 rpm for 30 seconds with the mixer V-mini300. Next, a mold was prepared by cutting a hole with a diameter of 30 mm at the center of a Teflon (registered trademark) sheet of 40 mm square with a thickness of 1 mm, and this mold was sandwiched between glass plates of 40 mm square with a thickness of 3 mm with a Teflon (registered trademark) sheet of 40 mm square with a thickness of 0.3 mm disposed therebetween. The mixed resin composition was filled in this mold. Both faces of the mold filled with the resin composition were irradiated with UV of 2500 mJ/cm$^2$ by using a belt conveyor type UV irradiation unit VB-15201BY (manufactured by Ushio Inc.), so as to perform the primary curing. Thereafter, the mold was placed in a high temperature chamber ST-120 (manufactured by Espec Corp.), so as to perform the secondary curing at 150°C for 30 minutes.

(Comparative Example 4)

Fifty parts by weight each of silicone resins KE109A and KE109B (manufactured by Shin-Etsu Silicones Co., Ltd.) and 100 parts by weight of anatase-type titanium oxide (manufactured by Kojundo Chemical Laboratory Co., Ltd.) were put in a dedicated vessel for a rotation/revolution type degassing mixer and were stirred with a rotation/revolution type degassing mixer V-mini300 (manufactured by EME corporation) at a revolution speed of 1600 rpm and a rotation speed of 800 rpm for 4 minutes. The resultant resin composition was filled in a syringe while stirring at a revolution speed of 1000 rpm and a rotation speed of 500 rpm for 30 seconds with the mixer V-mini300. Next, a mold was prepared by cutting a hole with a diameter of 30 mm at the center of a Teflon (registered trademark) sheet of 40 mm square with a thickness of 1 mm, and this mold was sandwiched between glass plates of 40 mm square with a thickness of 3 mm with a Teflon (registered trademark) sheet of 40 mm square with a thickness of 0.3 mm disposed therebetween. The mixed resin composition was filled in this mold. Thereafter, the mold filled with the resin composition was placed in a high temperature chamber ST-120 (manufactured by Espec Corp.), so as to perform curing at 150°C for 30 minutes.

(Comparative Example 5)

Hundred parts by weight of Adamantate X-M-1 04 (manufactured by IDEMITSU KOSAN Co., Ltd.), 0.005 part by weight of IRGACURE184 (manufactured by Ciba Japan) and 100 parts by weight of anatase-type titanium oxide (manufactured by Kojundo Chemical Laboratory Co., Ltd.) were put in a dedicated vessel for a rotation/revolution type degassing mixer and were stirred with a rotation/revolution type degassing mixer V-mini300 (manufactured by EME corporation) at a revolution speed of 1600 rpm and a rotation speed of 800 rpm for 4 minutes. The resultant resin composition was filled in a syringe while stirring at a revolution speed of 1000 rpm and a rotation speed of 500 rpm for 30 seconds with the mixer V-mini300. Next, a mold was prepared by cutting a hole with a diameter of 30 mm at the center of a Teflon (registered trademark) sheet of 40 mm square with a thickness of 1 mm, and this mold was sandwiched between glass plates of 40 mm square with a thickness of 3 mm with a Teflon (registered trademark) sheet of 40 mm square with a thickness of 0.3 mm disposed therebetween. The mixed resin composition was filled in this mold. Both faces of the mold filled with the resin composition were irradiated with UV of 2500 mJ/cm$^2$ by using a belt conveyor type UV irradiation unit VB-15201BY (manufactured by Ushio Inc.), so as to perform the primary curing. Thereafter, the mold was placed in a high temperature chamber ST-120 (manufactured by Espec Corp.), so as to perform the secondary curing at 150°C for 30 minutes.

(Measurement of Reflectance)

The highly reflective white material obtained in each of the aforementioned Examples and Comparative Examples was attached on an automatic recording U-3500 spectrophotometer (manufactured by Hitachi High-Technologies Corporation) using a 150 φ integrating sphere for measuring total reflectance at a wavelength of 350 through 800 nm. It is noted that barium sulfate was used as a reference in the measurement.
The measurement results for the total reflectance thus obtained are listed in Table 1 below.

Table 1

| Name of Product | Example 1 | Example 2 | Example 3 | Example 4 | Example 5 | Example 6 | Comparative Example 1 | Comparative Example 2 | Comparative Example 3 | Comparative Example 4 | Comparative Example 5 |
|---|---|---|---|---|---|---|---|---|---|---|---|
| Adamate X-M-104 | 20 | 40 | 50 | 60 | 80 | 90 | 10 | 0 | 100 | 0 | 100 |
| KE-109A | 40 | 30 | 25 | 20 | 10 | 5 | 45 | 50 | 0 | 50 | 0 |
| KE-109B | 40 | 30 | 25 | 20 | 10 | 5 | 45 | 50 | 0 | 50 | 0 |
| IRGACURE 184 | 0.005 | 0.005 | 0.005 | 0.005 | 0.005 | 0.005 | 0.005 | - | 0.005 | - | 0.005 |
| TITANIA | - | - | - | - | - | - | - | - | - | 100 | 100 |
| | | | | | | | | | | | |
| Reflectance at 350nm /% | 70 | 71.9 | 74 | 72.3 | 70 | 70.2 | 52.3 | 38.5 | 34.3 | 7.55 | 9.35 |
| Reflectance at 460nm /% | 87.4 | 90 | 90.9 | 90.9 | 90.9 | 91 | 65.9 | 40.6 | 36.4 | 99.4 | 94.8 |
| Reflectance at 800nm /% | 85.1 | 85.4 | 85.3 | 85.9 | 86.2 | 86.1 | 64.8 | 37.2 | 32.2 | 93.5 | 93.4 |

A sample of the reflective material of each of Examples 1 through 6 exhibits total reflectance of 70% or more at a wavelength of 350 nm, total reflectance of 85% or more at a wavelength of 460 nm and total reflectance of 85% or more at a wavelength of 800 nm. On the other hand, a sample of the reflective material of each of Comparative Examples 1 through 3 exhibit total reflectance of 70% or less at a wavelength of 350 nm, total reflectance of 85% or less at a wavelength of 460 nm and total reflectance of 85% or less at a wavelength of 800 nm. Thus, the highly reflective white material of this invention is obviously superior. Furthermore, a sample of the reflective material of each of Comparative Examples 4 and 5 exhibits total reflectance of 95% or more at a wavelength of 460 nm and total reflectance of 90% or more at a wavelength of 800 nm, which are superior to the reflectance attained by the present invention, but its total reflectance at a wavelength of 350 nm is extremely as low as 10%, and hence, the reflective material of the present invention is obviously superior as a whole.

The highly reflective white material of this embodiment may be used in a reflector for a backlight of a liquid crystal display, a reflector used in any of various types of lightings, a reflector included in an LED package or the like.

(EMBODIMENT 2)

Embodiment 2 of the invention will now be described in detail.

A highly reflective white material of this embodiment is obtained by curing a resin composition for a reflective material obtained by mixing a mixed resin, which includes, as 100 parts by weight in total, 20 through 50 parts by weight of an adamantane resin having an acrylic functional group and 50 through 80 parts by weight of a silicone resin, a curative agent and 100 or more parts by weight of alumina in the form of spherical particles.

Since the adamantane resin having an acrylic functional group, the silicone resin, the curative agent and the filler are mixed in a prescribed ratio so as to cause a radical polymerization reaction through irradiation with light, a resultant resin composition is whitened, and the curing is completed by further heating the resultant resin composition. Furthermore, since the filler is used together, the reflectance is improved as well as the heat resistance is improved.

As the filler, an inorganic material generally used as a white pigment such as alumina, titania or zinc oxide, or an organic material made of a hollow polymer in which a space is formed inside and the polymer is highly cross-linked may be used, and from the viewpoint of the heat resistance, an inorganic material is preferably used. When an inorganic material is used, the reflectance and the heat resistance are improved. Specifically, alumina has an advantage that the reflectance is comparatively less degraded in a wavelength region of 350 through 800 nm, but in using titania or zinc oxide, the reflectance is largely lowered in a wavelength region shorter than approximately 400 nm. Moreover, with respect to the shape of the alumina particles, reflectance of 90% or more may be attained in the wavelength region of 350 through 800 nm when the spherical shape is employed but the reflectance is lowered by approximately 10% in employing a scaly shape.

The adamantane resin having an acrylic functional group is preferably 1-adamantyl methacrylate.

The silicone resin is preferably additional reaction type silicone rubber.

The curative agent is preferably a radial photopolymerization initiator.

The radical photopolymerization initiator is preferably alkylphenone-based photopolymerization initiator.

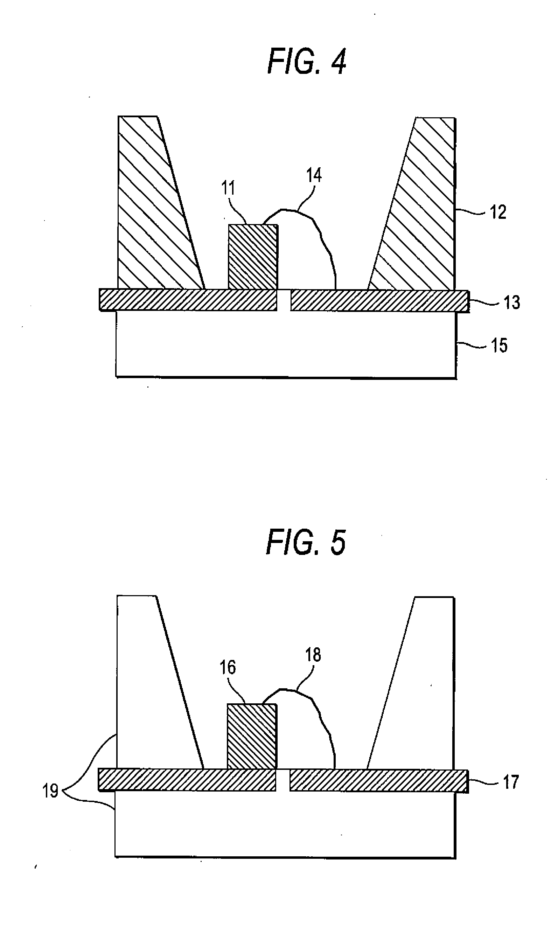

FIG. 4 is a cross-sectional view of an LED package in which a light emitting device 11, a reflector 12 and a lead frame 13 are molded with a highly reflective white material 15 with one end of the light emitting device 11 and one end of the lead frame 13 bonded to each other through a wire 14. The fabrication process for the highly reflective white material of this embodiment is the same as that of Embodiment 1. Furthermore, this embodiment is basically the same as Embodiment 1 except for components of the highly reflective white material.

When this structure is employed, the lead frame and the reflector may be simultaneously adhered in molding them, and hence, a dedicated adhesive for adhering the reflector and the lead frame may be omitted. Furthermore, since the highly reflective white material 15 is molded also in a gap formed in the lead frame, as compared with the case where a commercially available mold resin is used, degradation of the reflectance caused in passing through a solder reflow furnace is very small.

FIG. 5 is a cross-sectional view of an LED package in which a light emitting device 16 and a lead frame 17 bonded to each other through a wire 18 are molded with a highly reflective white material 19 with a reflector also made of the highly reflective white material 19.

When this structure is employed, the reflector may be also made of the highly reflective white material 19, and hence the production process may be shortened.

This embodiment will now be specifically described, and it is noted that the present invention is not limited to examples mentioned below.

(Example 1)

Twenty parts by weight of Adamantate X-M-104 (manufactured by IDEMITSU KOSAN Co., Ltd.), 40 parts by weight each of silicone resins KE109A and KE109B (manufactured by Shin-Etsu Silicones Co., Ltd.), 0.005 part by weight of IRGACURE 184 (manufactured by Ciba Japan) and 100 parts by weight of spherical alumina particles, ADMAFINE AO-502 (manufactured by ADMATECHS Co., Ltd.) were put in an agate motor, and the agate motor was set in an automatic motor AMM-140D (manufactured by Nitto Kagaku Co., Ltd.) for mixing the components for 10 minutes. Then, the thus obtained resin composition was put in a dedicated vessel for a rotation/revolution type degassing mixer and were stirred with a rotation/revolution type degassing mixer V-mini300 (manufactured by EME corporation) at a revolution speed of 1600 rpm and a rotation speed of 800 rpm for 4 minutes. The resultant resin composition was filled in a syringe while stirring at a revolution speed of 1000 rpm and a rotation speed of 500 rpm for 30 seconds with the mixer V-mini300. Next, a mold was prepared by cutting a hole with a diameter of 30 mm at the center of a Teflon (registered trademark) sheet of 40 mm square with a thickness of 1 mm, and this mold was sandwiched between glass plates of 40 mm square with a thickness of 3 mm with a Teflon (registered trademark) sheet of 40 mm square with a thickness of 0.3 mm disposed therebetween. The mixed resin composition was filled in this mold. Both faces of the mold filled with the resin composition were irradiated with UV of 2500 mJ/cm$^2$ by using a belt conveyor type UV irradiation unit VB-15201BY (manufactured by Ushio Inc.), so as to perform the primary curing. Thereafter, the mold was placed in a high temperature chamber ST-120 (manufactured by Espec Corp), so as to perform the secondary curing at 150°C for 30 minutes.

(Example 2)

The fabrication process was carried out in the same manner as in Example 1 except that 150 parts by weight of ADMAFINE AO-502 (manufactured by ADMATECHS Co., Ltd.) was used.

(Example 3)

The fabrication process was carried out in the same manner as in Example 1 except that 40 parts by weight of Adamantate X-M-104 (manufactured by IDEMITSU KOSAN Co., Ltd.) and 30 parts by weight each of silicone resins KE109A and KE109B (manufactured by Shin-Etsu Silicones Co., Ltd.) were used.

(Example 4)

The fabrication process was carried out in the same manner as in Example 1 except that 40 parts by weight of Adamantate X-M-104 (manufactured by IDEMITSU KOSAN Co., Ltd.), 30 parts by weight each of silicone resins KE109A and KE109B (manufactured by Shin-Etsu Silicones Co., Ltd.) and 150 parts by weight of ADMAFINE AO-502 (manufactured by ADMATECHS Co., Ltd.) were used.

(Example 5)

The fabrication process was carried out in the same manner as in Example 1 except that 50 parts by weight of Adamantate X-M-104 (manufactured by IDEMITSU KOSAN Co., Ltd.) and 25 parts by weight each of silicone resins KE1 09A and KE109B (manufactured by Shin-Etsu Silicones Co., Ltd.) were used.

(Example 6)

The fabrication process was carried out in the same manner as in Example 1 except that 50 parts by weight of Adamantate X-M-104 (manufactured by IDEMITSU KOSAN Co., Ltd.), 25 parts by weight each of silicone resins KE1 09A and KE109B (manufactured by Shin-Etsu Silicones Co., Ltd.) and 150 parts by weight of ADMAFINE AO-502 (manufactured by ADMATECHS Co., Ltd.) were used.

(Comparative Example 1)

The fabrication process was carried out in the same manner as in Example 1 except that 30 parts by weight of ADMAFINE AO-502 (manufactured by ADMATECHS Co., Ltd.) was used.

(Comparative Example 2)

The fabrication process was carried out in the same manner as in Example 1 except that 40 parts by weight of Adamantate X-M-104 (manufactured by IDEMITSU KOSAN Co., Ltd.), 30 parts by weight each of silicone resins KE1 09A and KE109B (manufactured by Shin-Etsu Silicones Co., Ltd.) and 30 parts by weight of ADMAFINE AO-502 (manufactured by ADMATECHS Co., Ltd.) were used.

(Comparative Example 3)

The fabrication process was carried out in the same manner as in Example 1 except that 50 parts by weight of Adamantate X-M-104 (manufactured by IDEMITSU KOSAN Co., Ltd.), 25 parts by weight each of silicone resins KE109A and KE109B (manufactured by Shin-Etsu Silicones Co., Ltd.) and 30 parts by weight of ADMAFINE AO-502 (manufactured by ADMATECHS Co., Ltd.) were used.

(Comparative Example 4)

The fabrication process was carried out in the same manner as in Example 1 except that Adamantate X-M-1 04 (manufactured by IDEMITSU KOSAN Co., Ltd.) and IRGACURE 184 (manufactured by Ciba Japan) were not used, 50 parts by weight each of silicone resins KE109A and KE109B (manufactured by Shin-Etsu Silicones Co., Ltd.) were used, and the primary curing through the irradiation with UV by using the belt conveyor type UV irradiation unit VB-15201 BY (manufactured by Ushio Inc.) was not performed.

(Comparative Example 5)

The fabrication process was carried out in the same manner as in Example 1 except that 60 parts by weight of Adamantate X-M-104 (manufactured by IDEMITSU KOSAN Co., Ltd.) and 20 parts by weight each of silicone resins KE109A and KE109B (manufactured by Shin-Etsu Silicones Co., Ltd.) were used.

(Comparative Example 6)

The fabrication process was carried out in the same manner as in Example 1 except that 80 parts by weight of Adamantate X-M-104 (manufactured by IDEMITSU KOSAN Co., Ltd.) and 10 parts by weight each of silicone resins KE109A and KE109B (manufactured by Shin-Etsu Silicones Co., Ltd.) were used.

(Comparative Example 7)

The fabrication process was carried out in the same manner as in Example 1 except that 100 parts by weight of Adamantate X-M-104 (manufactured by IDEMITSU KOSAN Co., Ltd.) was used and the silicone resins KE109A and KE109B (manufactured by Shin-Etsu Silicones Co., Ltd.) were not used.

(Comparative Example 8)

The fabrication process was carried out in the same manner as in Example 1 except that plate-shaped alumina particles, SERATH YFA05070 (manufactured by Kinsei Matec Co., Ltd.) were used in place of the spherical alumina particles, ADMAFINE AO-502 (manufactured by ADMATECHS Co., Ltd.).

(Comparative Example 9)

The fabrication process was carried out in the same manner as in Example 1 except that rutile-type titanium oxide TIO13PB (manufactured by Kojundo Chemical Laboratory Co., Ltd.) was used in place of the spherical alumina particles, ADMAFINE AO-502 (manufactured by ADMATECHS Co., Ltd.).

(Comparative Example 10)

The fabrication process was carried out in the same manner as in Example 1 except that anatase-type titanium oxide TIO17PB (manufactured by Kojundo Chemical Laboratory Co., Ltd.) was used in place of the spherical alumina particles, ADMAFINE AO-502 (manufactured by ADMATECHS Co., Ltd.).

(Comparative Example 11)

The fabrication process was carried out in the same manner as in Example 1 except that zinc oxide ZNO03PB (manufactured by Kojundo Chemical Laboratory Co., Ltd.) was used in place of the spherical alumina particles, ADMAFINE AO-502 (manufactured by ADMATECHS Co., Ltd.).

(Measurement of Reflectance)

The highly reflective white material obtained in each of the aforementioned Examples and Comparative Examples was attached on an automatic recording U-3500 spectrophotometer (manufactured by Hitachi High-Technologies Corporation) using a 150 φ integrating sphere for measuring total reflectance at a wavelength of 350 through 800 nm. It is noted that barium sulfate was used as a reference in the measurement.

The measurement results for the total reflectance thus obtained are listed in Table 2 below.

Table 2 　　　　※ Heat treatment: 1 hour at 260°C

| Name of Product | Example 1 | Example 2 | Example 3 | Example 4 | Example 5 | Example 6 | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 | Comparative Example 10 | Comparative Example 11 |
|---|---|---|---|---|---|---|---|---|---|---|---|---|---|---|---|---|---|
| Adamate X-M-104 | 20 | 20 | 40 | 40 | 50 | 50 | 20 | 40 | 50 | 0 | 50 | 80 | 100 | 20 | 20 | 20 | 20 |
| KE-109A | 40 | 40 | 30 | 30 | 25 | 25 | 40 | 30 | 25 | 50 | 20 | 10 | 0 | 40 | 40 | 40 | 40 |
| KE-109B | 40 | 40 | 30 | 30 | 25 | 25 | 40 | 30 | 25 | 50 | 20 | 10 | 0 | 40 | 40 | 40 | 40 |
| IRGACURE 184 | 0.005 | 0.005 | 0.005 | 0.005 | 0.005 | 0.005 | 0.005 | 0.005 | 0.005 | - | 0.005 | 0.005 | 0.005 | 0.005 | 0.005 | 0.005 | 0.005 |
| Spherical alumina | 100 | 150 | 100 | 150 | 100 | 150 | 100 | 100 | 100 | 100 | 100 | 100 | 100 | - | - | - | - |
| Plate shaped Almina | - | - | - | - | - | - | - | - | - | - | - | - | - | 100 | - | - | - |
| Rutile-type titanium oxide | - | - | - | - | - | - | - | - | - | - | - | - | - | - | 100 | - | - |
| Anatase-type titanium oxide | - | - | - | - | - | - | - | - | - | - | - | - | - | - | - | 100 | - |
| zinc oxide | - | - | - | - | - | - | - | - | - | - | - | - | - | - | - | - | 100 |
| Reflectance at 800nm /% | 100 | 100.0 | 99.8 | 98.8 | 99.2 | 99.2 | 94.9 | 93.5 | 92..7 | 96.3 | 98.1 | 95.5 | 86.9 | 85.9 | 100 | 95.7 | 99.7 |
| Reflectance at 460 nm /% | 100 | 100.0 | 100 | 100 | 100 | 100 | 99.2 | 98.6 | 97.3 | 99 | 99.3 | 98.5 | 91.5 | 86.4 | 100 | 98.3 | 100 |
| Reflectance at 350nm /% | 86.3 | 89.5 | 87.1 | 86.6 | 88.2 | 89.2 | 86.5 | 83.4 | 80.5 | 84.3 | 92.6 | 97 | 64.5 | 81.2 | 5.5 | 7.6 | 5.4 |
| Reflectance at 800nm /% After heat treatment※ | 97.8 | 98.6 | 98.2 | 98.3 | 98.8 | 98.9 | 94.6 | 93.8 | 93.4 | 95.9 | 97.9 | 96.3 | 75.2 | 84.2 | 99.7 | 92.2 | 99.0 |
| Reflectance at 460 nm /% After heat treatment※ | 96.6 | 97.2 | 95.4 | 96.2 | 94 | 93.1 | 81.6 | 79.9 | 78.3 | 95 | 89.2 | 82.4 | 53.7 | 71.1 | 88.0 | 86.6 | 93.9 |
| Reflectance at 350nm /% After heat treatment※ | 81.4 | 86.3 | 80.3 | 81.3 | 78.7 | 79.2 | 56.7 | 54.5 | 53.0 | 72.9 | 73.1 | 62 | 16.5 | 50.6 | 5.5 | 7.6 | 5.3 |

A sample of the reflective material of each of Examples 1 through 6 exhibits, with respect to the initial reflectance, total reflectance of 86% or more at a wavelength of 350 nm, total reflectance of 100% at a wavelength of 460 nm and total reflectance of 98% or more at a wavelength of 800 nm, and with respect to reflectance attained after a heat treatment of 1 hour at 260°C, exhibits total reflectance of 78% or more at a wavelength of 350 nm, total reflectance of 93% or more at a wavelength of 460 nm and total reflectance of 9.7% or more at a wavelength of 800 nm.

On the other hand, a sample of the reflective material of each of Comparative Examples 1 through 3 where the amount of alumna is small exhibits, with respect to the initial reflectance, total reflectance of 80% or more at a wavelength of 350 nm, total reflectance of 97% or more at a wavelength of 460 nm and total reflectance of 92% or more at a wavelength of 800 nm, and with respect to the reflectance attained after a heat treatment of 1 hour at 260°C, total reflectance of 56% is exhibited at a wavelength of 350 nm by a sample having the highest reflectance, total reflectance of 82% is exhibited at a wavelength of 460 nm by a sample having the highest reflectance, and total reflectance of 95% is exhibited at a wavelength of 800 nm by a sample having the highest reflectance. Thus, the reflectance attained after the heat treatment of 1 hour at 260°C is largely degraded in Comparative Examples 1 through 3 than in Examples, and hence, the highly reflective white material of this invention is obviously superior. Furthermore, a sample of the reflective material of each of Comparative Examples 4 through 7 where the composition ratio of the resin compositions are different exhibits, with respect to the initial reflectance, total reflectance of 64% or more at a wavelength of 350 nm, total reflectance of 91% or more at a wavelength of 460 nm and total reflectance of 87% or more at a wavelength of 800 nm, and with respect to the reflectance after a heat treatment of 1 hour at 260°C, total reflectance of 73% is exhibited at a wavelength of 350 nm by a sample having the highest reflectance, total reflectance of 98% is exhibited at a wavelength of 460 nm by a sample having the highest reflectance, and total reflectance of 95% is exhibited at a wavelength of 800 nm by a sample having the highest reflectance. Thus, the reflectance attained after the heat treatment of 1 hour at 260°C is largely degraded in Comparative Examples 4 through 7 than in Examples, and hence, the highly reflective white material of this invention is obviously superior. Furthermore, a sample of the reflective material of Comparative Example 8 where the shape of the alumina used as the filler is changed exhibits, with respect to the initial reflectance, total reflectance of 81 % or more at a wavelength of 350 nm, total reflectance of 86% or more at a wavelength of 460 nm and total reflectance of 86% or more at a wavelength of 800 nm, and with respect to the reflectance attained after a heat treatment of 1 hour at 260°C, total reflectance of 51 % at a wavelength of 350 nm, total reflectance of 71 % at a wavelength of 460 nm, and total reflectance of 84% at a wavelength of 800 nm. Thus, the reflectance is lower than in Examples even at the initial stage, and the highly reflective white material of the invention is obviously superior. Furthermore, a sample of the reflective material of each of Comparative Examples 9 through 11 where the type of filler to be filled is changed exhibits, with respect to the initial reflectance, total reflectance of 10% or less at a wavelength of 350 nm, total reflectance of 98% or more at a wavelength of 460 nm and total reflectance of 95% or more at a wavelength of 800 nm, and with respect to the reflectance attained after a heat treatment of 1 hour at 260°C, exhibits total reflectance of 10% or less at a wavelength of 350 nm, total reflectance of 86% is exhibited at a wavelength of 460 nm by a sample having the highest reflectance, and total reflectance of 92% is exhibited at a wavelength of 800 nm by a sample having the highest reflectance. Thus, the initial reflectance particularly at a wavelength of 350 nm is largely degraded as compared with that attained in Examples, and hence, the highly reflective white material of this invention is obviously superior.

It is noted that the aforementioned effects may be attained by using 100 or more parts by weight of the spherical alumina in the highly reflective white material in this embodiment, but when the amount of the filler is too large, it is necessary to use a dispersing agent or the like, and a dispersing agent is vulnerable to heat. Therefore, the amount of filler to be included in the highly reflective white material is preferably 150 parts by weight or less.

The highly reflective white material of this embodiment may be used in a reflector for a backlight of a liquid crystal display, a reflector used in any of various lightings, a reflector included in an LED package or the like.

(EMBODIMENT 3)

A highly reflective white material of this embodiment is obtained by curing a resin composition for a reflective material obtained by mixing a mixed resin, which includes, as 100 parts by weight in total, 20 through 50 parts by weight of an adamantane resin having an acrylic functional group and 50 through 80 parts by weight of a silicone resin, 1 through 2 parts by weight of a radical thermopolymerization initiator, and 100 or more parts by weight of alumina in the form of spherical particles.

Since the adamantane resin having an acrylic functional group, the silicone resin, the radical thermopolymerization initiator and the filler are mixed in a prescribed ratio so as to cause a radical polymerization reaction, a resultant resin composition is cured and whitened. Furthermore, since the filler is used together, the reflectance is improved as well as the heat resistance is improved.

As the filler, an inorganic material generally used as a white pigment such as alumina, titania or zinc oxide, or an organic material made of a hollow polymer in which a space is formed inside and the polymer is highly crosslinked may be used, and from the viewpoint of the heat resistance, an inorganic material is preferably used. When an inorganic material is used, the reflectance and the heat resistance are improved. Specifically, alumina has an advantage that the reflectance is comparatively less degraded in a wavelength region of 350 through 800 nm, but in using titania or zinc oxide, the reflectance is largely lowered in a wavelength region shorter than approximately 400 nm. Moreover, with respect to the shape of the alumina particles, reflectance of 90% or more may be attained in the wavelength region of 350 through 800 nm when the spherical shape is employed but the reflectance is lowered by approximately 10% in employing a scaly shape.

The adamantane resin having an acrylic functional group is preferably 1-adamatyl methacrylate.

The silicone resin is preferably additional reaction type silicone rubber.

The radical thermopolymerization initiator is preferably an organic peroxide-based thermopolymerization initiator.

Radical thermopolymerization initiators include an organic peroxide-based radical polymerization initiator and an azo compound-based radical polymerization initiator. A highly reflective white material may be obtained no matter which polymerization initiator is used, but the organic peroxide-based polymerization initiator is superior in the heat resistance. Examples of the organic peroxide-based radical polymerization initiator are products of peroxy ketal, hydroperoxide, dialkyl peroxide, diacyl peroxide, peroxy dicarbonate and peroxy ester commercially available from NOF Corporation. In the reaction of this embodiment, radicals are generated for whitening a resin composition, and hence, other cationic or anionic polymerization initiators are not suitably used. It is noted that the fabrication process for a highly reflective white material of this embodiment is the same as that of Embodiment 1. Furthermore, this embodiment is basically the same as Embodiment 1 except for the compositions of components of the highly reflective white material. This embodiment is also basically the same as Embodiment 2 except that a radical thermopolymerization initiator is used in place of the radical photopolymerization initiator.

A resin composition used in the highly reflective white material of this embodiment, which is obtained by mixing the mixed resin including, as 100 parts by weight in total, 20 through 50 parts by weight of the adamantane resin having an acrylic functional group and 50 through 80 parts by weight of the silicone resin, and 1 through 2 parts by weight of the radical thermopolymerization initiator and by heating the resultant mixture, has the following structure: Absorption peaks in the vicinity of 1700 cm$^{-1}$ and in the vicinity of 1050 through 1400 cm$^{-1}$ obtained through infrared absorption spectrometry before the curing and peculiar to the functional group included in an acrylic group are found to become smaller through the curing with heat. Accordingly, it is found that the resin composition is cured through a reaction with the silicone resin through the acrylic group, that is, the functional group of the adamantane resin.

Now, the present embodiment will be described with reference to the accompanying drawings.

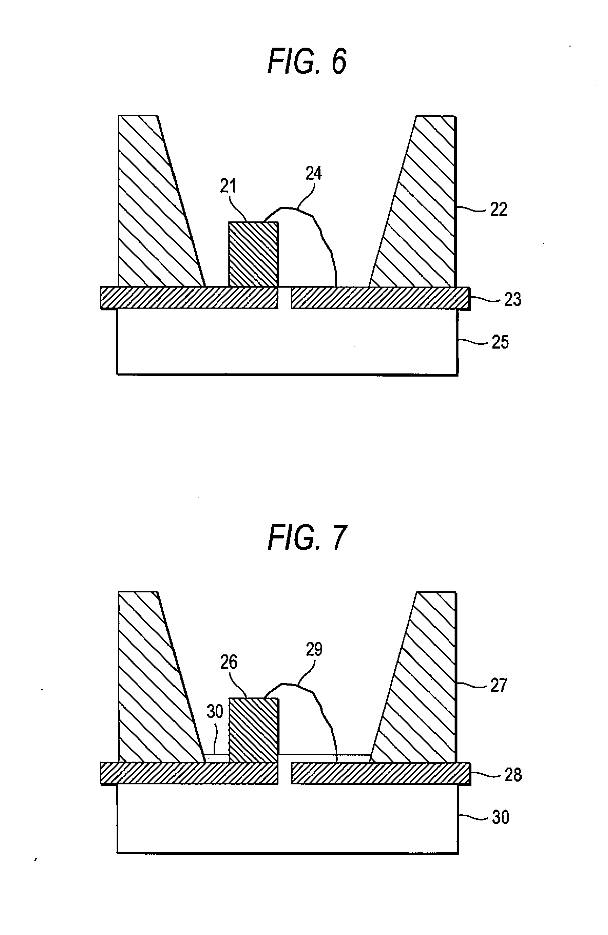

FIG. 6 is a cross-sectional view of an example of an LED package using the highly reflective white material of this embodiment, and specifically, is a cross-sectional view of an LED package in which a light emitting device 21, a reflector 22 and a lead frame 23 are molded with a highly reflective white material 25 with one end of the light emitting device 21 and one end of the lead frame 23 bonded to each other through a wire 24.

When this structure is employed, the lead frame and the reflector may be simultaneously adhered in molding them, and hence, a dedicated adhesive for adhering the reflector and the lead frame may be omitted. Furthermore, since the highly reflective white material 25 is molded also in a gap formed in the lead frame, as compared with the case where a commercially available mold resin is used, degradation of the reflectance caused in passing through a solder reflow furnace is very small.

FIG. 7 is a cross-sectional view of another example of the LED package using the highly reflective white material of this embodiment, and specifically, is a cross-sectional view of an LED package in which a light emitting device 26 and a lead frame 28 bonded to each other through a wire 29 are molded with a highly reflective white material 30. Further, a portion of the lead frame 28 other than a portion for wire bonding is made of the highly reflective white material 30.

When this structure is employed, an effect to prevent the surface of the lead frame from becoming black through sulfuration may be attained.

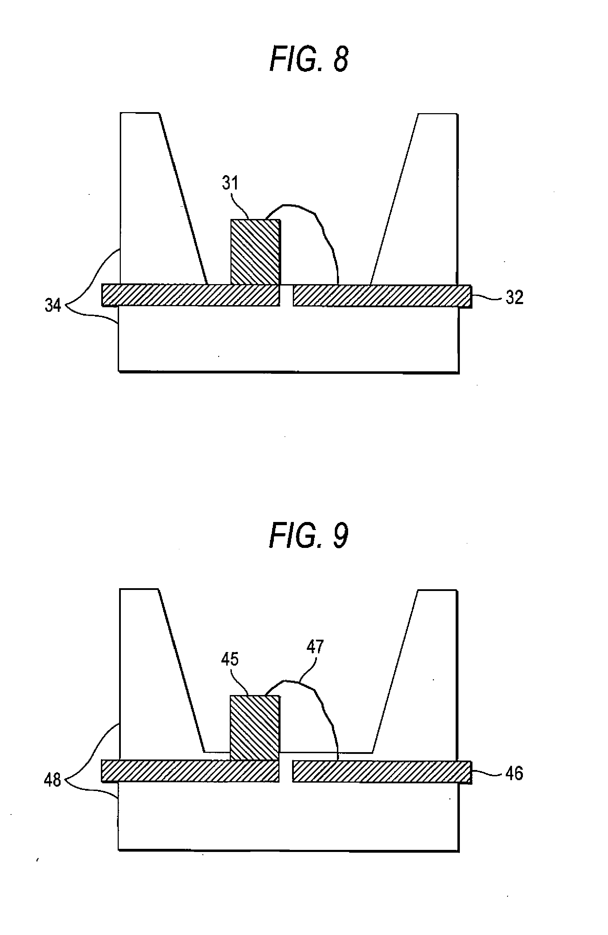

FIG. 8 is a cross-sectional view of another example of the LED package using the highly reflective white material 34 of this embodiment, and specifically, is a cross-sectional view of an LED package in which a light emitting device 31, a reflector 34 and a lead frame 32 are molded with a highly reflective white material 34 with a reflector 34 also made of the highly reflective white material 34.

When this structure is employed, the reflector may be also made of the highly reflective white material 29, and hence the production process may be shortened.

FIG. 9 is a cross-sectional view of another example of the LED package using the highly reflective white material of this embodiment, and specifically, is a cross-sectional view of an LED package in which a light emitting device 45 and a lead frame 46 bonded to each other through a wire are molded with a highly reflective white material 48 and a reflector 48 and a portion of the lead frame 46 other than a portion for wire bonding are made of the highly reflective white material 48.

When this structure is employed, in addition to the effect attained by the structure of FIG. 7, an effect to prevent the surface of the lead frame from becoming black through sulfuration may be attained.

Now, the present embodiment will be specifically described and it is noted that the invention is not limited to examples mentioned below.

(Example 1)

Twenty parts by weight of Adamantate X-M-104 (manufactured by IDEMITSU KOSAN Co., Ltd.), 40 parts by weight each of silicone resins KE109A and KE109B (manufactured by Shin-Etsu Silicones Co., Ltd.) and 1 part by weight of PEROCTA O (manufactured by NOF Corporation) were put in an agate motor, and the agate motor was set in an automatic motor AMM-140D (manufactured by Nitto Kagaku Co., Ltd.) for mixing the components for 5 minutes. To the resultant, 100 parts by weight of spherical alumina particles, ADMAFINE AO-502 (manufactured by ADMATECHS Co., Ltd.) were added little by little, and after adding the total amount, the resultant mixture is mixed for another 30 minutes. Then, the thus obtained resin composition was put in a dedicated vessel for a rotation/revolution type degassing mixer and were stirred with a rotation/revolution type degassing mixer V-mini300 (manufactured by EME corporation) at a revolution speed of 1600 rpm and a rotation speed of 800 rpm for 4 minutes. The resultant resin composition was filled in a syringe while stirring at a revolution speed of 1400 rpm and a rotation speed of 700 rpm for 30 seconds with the mixer V-mini300. Next, a mold was prepared by cutting a hole with a diameter of 30 mm at the center of a Teflon (registered trademark) sheet of 40 mm square with a thickness of 1 mm, and this mold was sandwiched between glass plates of 40 mm square with a thickness of 3 mm with a Teflon (registered trademark) sheet of 40 mm square with a thickness of 0.3 mm disposed therebetween. The mixed resin composition was filled in this mold. Thereafter, the mold filled with the resin composition was placed in a high temperature chamber ST-120 (manufactured by Espec Corp), so as to perform the curing at 150°C for 30 minutes.

(Example 2)

The fabrication process was carried out in the same manner as in Example 1 except that 220 parts by weight of ADMAFINE AO-502 (manufactured by ADMATECHS Co., Ltd.) was used.

(Example 3)

The fabrication process was carried out in the same manner as in Example 1 except that 2 parts by weight of PEROCTA O (manufactured by NOF Corporation) was used.

(Example 4)

The fabrication process was carried out in the same manner as in Example 1 except that 300 parts by weight of ADMAFINE AO-502 (manufactured by ADMATECHS Co., Ltd.) was used.

(Example 5)

The fabrication process was carried out in the same manner as in Example 1 except that 40 parts by weight of Adamantate X-M-104 (manufactured by IDEMITSU KOSAN Co., Ltd.) and 30 parts by weight each of silicone resins KE109A and KE109B (manufactured by Shin-Etsu Silicones Co., Ltd.) were used.

(Example 6)

The fabrication process was carried out in the same manner as in Example 1 except that 40 parts by weight of Adamantate X-M-104 (manufactured by IDEMITSU KOSAN Co., Ltd.), 30 parts by weight each of silicone resins KE109A and KE109B (manufactured by Shin-Etsu Silicones Co., Ltd.) and 200 parts by weight of ADMAFINE AO-502 (manufactured by ADMATECHS Co., Ltd.) were used.

(Example 7)

The fabrication process was carried out in the same manner as in Example 1 except that 40 parts by weight of Adamantate X-M-104 (manufactured by IDEMITSU KOSAN Co., Ltd.), 30 parts by weight each of silicone resins KE109A and KE109B (manufactured by Shin-Etsu Silicones Co., Ltd.) and 300 parts by weight of ADMAFINE AO-502 (manufactured by ADMATECHS Co., Ltd.) were used.

(Example 8)

The fabrication process was carried out in the same manner as in Example 1 except that 50 parts by weight of Adamantate X-M-104 (manufactured by IDEMITSU KOSAN Co., Ltd.) and 25 parts by weight each of silicone resins KE109A and KE109B (manufactured by Shin-Etsu Silicones Co., Ltd.) were used.

(Example 9)

The fabrication process was carried out in the same manner as in Example 1 except that 50 parts by weight of Adamantate X-M-104 (manufactured by IDEMITSU KOSAN Co., Ltd.), 25 parts by weight each of silicone resins KE109A and KE109B (manufactured by Shin-Etsu Silicones Co., Ltd.) and 200 parts by weight of ADMAFINE AO-502 (manufactured by ADMATECHS Co., Ltd.) were used.

(Example 10)

The fabrication process was carried out in the same manner as in Example 1 except that 50 parts by weight of Adamantate X-M-104 (manufactured by IDEMITSU KOSAN Co., Ltd.), 25 parts by weight each of silicone resins KE109A and KE109B (manufactured by Shin-Etsu Silicones Co., Ltd.) and 300 parts by weight of ADMAFINE AO-502 (manufactured by ADMATECHS Co., Ltd.) were used.

(Comparative Example 1)

The fabrication process was carried out in the same manner as in Example 1 except that 0.5 part by weight of PEROCTA O (manufactured by NOF Corporation) was used.

(Comparative Example 2)

The fabrication process was carried out in the same manner as in Example 1 except that 2.5 parts by weight of PEROCTA O (manufactured by NOF Corporation) was used.

(Comparative Example 3)

The fabrication process was carried out in the same manner as in Example 1 except that 50 parts by weight of ADMAFINE AO-502 (manufactured by ADMATECHS Co., Ltd.) was used.

(Comparative Example 4)

The fabrication process was carried out in the same manner as in Example 1 except that 40 parts by weight of Adamantate X-M-104 (manufactured by IDEMITSU KOSAN Co., Ltd.), 30 parts by weight each of silicone resins KE1 09A and KE109B (manufactured by Shin-Etsu Silicones Co., Ltd.) and 50 parts by weight of ADMAFINE AO-502 (manufactured by ADMATECHS Co., Ltd.) were used.

(Comparative Example 5)

The fabrication process was carried out in the same manner as in Example 1 except that 50 parts by weight of Adamantate X-M-104 (manufactured by IDEMITSU KOSAN Co., Ltd.), 25 parts by weight each of silicone resins KE1 09A and KE109B (manufactured by Shin-Etsu Silicones Co., Ltd.) and 50 parts by weight of ADMAFINE AO-502 (manufactured by ADMATECHS Co., Ltd.) were used.

(Comparative Example 6)

The fabrication process was carried out in the same manner as in Example 1 except that Adamantate X-M-104 (manufactured by IDEMITSU KOSAN Co., Ltd.) was not used and 50 parts by weight each of silicone resins KE109A and KE109B (manufactured by Shin-Etsu Silicones Co., Ltd.) was used.

(Comparative Example 7)

The fabrication process was carried out in the same manner as in Example 1 except that 60 parts by weight of Adamantate X-M-104 (manufactured by IDEMITSU KOSAN Co., Ltd.) and 20 parts by weight each of silicone resins KE1 09A and KE109B (manufactured by Shin-Etsu Silicones Co., Ltd.) were used.

(Comparative Example 8)

The fabrication process was carried out in the same manner as in Example 1 except that 80 parts by weight of Adamantate X-M-104 (manufactured by IDEMITSU KOSAN Co., Ltd.) and 10 parts by weight each of silicone resins KE109A and KE109B (manufactured by Shin-Etsu Silicones Co., Ltd.) were used.

(Comparative Example 9)

The fabrication process was carried out in the same manner as in Example 1 except that 100 parts by weight of Adamantate X-M-104 (manufactured by IDEMITSU KOSAN Co., Ltd.) was used and the silicone resins KE109A and KE109B (manufactured by Shin-Etsu Silicones Co., Ltd.) were not used.

(Comparative Example 10)

The fabrication process was carried out in the same manner as in Example 1 except that plate-shaped alumina particles, SERATH YFA05070 (manufactured by Kinsei Matec Co., Ltd.) were used in place of the spherical alumina particles, ADMAFINE AO-502 (manufactured by ADMATECHS Co., Ltd.).

(Comparative Example 11)

The fabrication process was carried out in the same manner as in Example 1 except that rutile-type titanium oxide, TIO13PB (manufactured by Kojundo Chemical Laboratory Co., Ltd.) was used in place of the spherical alumina particles, ADMAFINE AO-502 (manufactured by ADMATECHS Co., Ltd.).

(Comparative Example 12)

The fabrication process was carried out in the same manner as in Example 1 except that anatase-type titanium oxide, TIO17PB (manufactured by Kojundo Chemical Laboratory Co., Ltd.) was used in place of the spherical alumina particle, ADMAFINE AO-502 (manufactured by ADMATECHS Co., Ltd.).

(Comparative Example 13)

The fabrication process was carried out in the same manner as in Example 1 except that zinc oxide, ZNO03PB (manufactured by Kojundo Chemical Laboratory Co., Ltd.) was used in place of the spherical alumina particles, ADMAFINE AO-502 (manufactured by ADMATECHS Co., Ltd.).

(Measurement of Reflectance)

The highly reflective white material obtained in each of the aforementioned Examples and Comparative Examples was attached on an automatic recording U-3500 spectrophotometer (manufactured by Hitachi High-Technologies Corporation) using a 150 φ integrating sphere for measuring total reflectance at a wavelength of 350 through 800 nm. It is noted that barium sulfate was used as a reference in the measurement.
The measurement results for the total reflectance thus obtained are listed in Table 3 below.

(Table 3)  ※ Heat treatment: 1 hour at 260°C

| Name of Product | Example 1 | Example 2 | Example 3 | Example 4 | Example 5 | Example 6 | Example 7 | Example 8 | Example 9 | Example 10 | Comparative Example 1 | Comparative Example 2 | Comparative Example 3 | Comparative Example 4 | Comparative Example 5 |
|---|---|---|---|---|---|---|---|---|---|---|---|---|---|---|---|
| Adamate X-M-104 | 20 | 20 | 20 | 20 | 40 | 40 | 40 | 50 | 50 | 50 | 20 | 20 | 20 | 40 | 50 |
| KE-109A | 40 | 40 | 40 | 40 | 30 | 30 | 30 | 25 | 25 | 25 | 40 | 40 | 40 | 30 | 25 |
| KE-109B | 40 | 40 | 40 | 40 | 30 | 30 | 30 | 25 | 25 | 25 | 40 | 40 | 40 | 30 | 25 |
| PEROCTA O | 1 | 1 | 2 | 1 | 1 | 1 | 1 | 1 | 1 | 1 | 0.5 | 2.5 | 1 | 1 | 1 |
| spherical alumina | 100 | 200 | 200 | 300 | 100 | 200 | 300 | 100 | 200 | 300 | 200 | 200 | 50 | 50 | 50 |
| Scale-like Almina | - | - | - | - | - | - | - | - | - | - | - | - | - | - | - |
| rutile-type titanium oxide | - | - | - | - | - | - | - | - | - | - | - | - | - | - | - |
| anatase-type titanium oxide | - | - | - | - | - | - | - | - | - | - | - | - | - | - | - |
| zinc oxide | - | - - | - | - | - | - | - | - | - | - | - | - | - | - | - |
| Reflectance at 800nm /% | 93.3 | 93.5 | 93.4 | 93.6 | 93.5 | 93.6 | 93.6 | 93.2 | 93.2 | 93.3 | 91.5 | 93.8 | 93.8 | 93.5 | 93.1 |
| Reflectance at 460 nm /% | 95.6 | 96.2 | 95.9 | 96.4 | 95.5 | 95.9 | 96.2 | 95.5 | 95.8 | 96.0 | 93.2 | 96.4 | 95.4 | 96.2 | 95.9 |
| Reflectance at 350nm /% | 83.2 | 83.6 | 93.1 | 84.1 | 83.3 | 83.1 | 83.5 | 82.9 | 83.2 | 83.6 | 78.6 | 83.5 | 82.6 | 82.3 | 81.3 |
| Reflectance at 800nm /% After heat treatment※ | 93.1 | 93.2 | 93.1 | 93.4 | 93 | 92.9 | 93.1 | 92.8 | 92.4 | 92.5 | 89.6 | 91.3 | 93.0 | 92.8 | 92.4 |
| Reflectance at 460 nm /% After heat treatment※ | 94.9 | 95.4 | 95.3 | 95.2 | 94.7 | 95 | 95.6 | 94.5 | 95 | 94.6 | 90.4 | 89.5 | 78.6 | 77.9 | 76.8 |
| Reflectance at 350nm /% After heat treatment※ | 77.9 | 78.0 | 76.8 | 76.8 | 76.6 | 76.8 | 77.1 | 76.3 | 76.5 | 76.7 | 71.0 | 70.6 | 57.6 | 54.5 | 55.1 |

A sample of the reflective material of each of Examples 1 through 10 exhibits, with respect to the initial reflectance, total reflectance of 80% or more at a wavelength of 350 nm, total reflectance of 95% or more at a wavelength of 460 nm, and total reflectance of 93% or more at a wavelength of 800 nm, and with respect to the reflectance attained after a heat treatment of 1 hour at 260°C, exhibits total reflectance of 75% or more at a wavelength of 350 nm, total reflectance of 92% or more at a wavelength of 460 nm and total reflectance or 90% or more at a wavelength of 800 nm.
On the other hand, a sample of the reflective material of Comparative Example 1 where the amount of the radical photopolymerization initiator is small exhibits, with respect to the initial reflectance, total reflectance of 78.6% at a wavelength of 350 nm, total reflectance of 93.2% at a wavelength of 460 nm and total reflectance of 91.5% at a wavelength of 800 nm, and with respect to the reflectance attained after a heat treatment of 1 hour at 260°C, exhibits total reflectance of 71% at a wavelength of 350 nm, total reflectance of 90.4% at a wavelength of 460 nm, and total reflectance of 89.6% at a wavelength of 800 nm. Thus, the reflectance attained after the heat treatment of 1 hour at 260°C is largely degraded in Comparative Example 1 than in Examples, and hence, the highly reflective white material of this invention is obviously superior. Moreover, a sample of the reflective material of Comparative Example 2 where the amount of the radical photopolymerization initiator is large exhibits, with respect to the initial reflectance, total reflectance of 83.5% at a wavelength of 350 nm, total reflectance of 96.4% at a wavelength of 460 nm and total reflectance of 93.8% at a wavelength of 800 nm, and with respect to the reflectance attained after a heat treatment of 1 hour at 260°C, exhibits total reflectance of 70.6% at a wavelength of 350 nm, total reflectance of 89.5% at a wavelength of 460 nm, and total reflectance of 91.3% at a wavelength of 800 nm. Thus, the reflectance attained after the heat treatment of 1 hour at 260°C is largely degraded in Comparative Example 2 than in Examples, and hence, the highly reflective white material of this invention is obviously superior. Furthermore, a sample of the reflective material of each of Comparative Examples 3 through 5 where the amount of alumina is small exhibits, with respect to the initial reflectance, total reflectance of 80% or more at a wavelength of 350 nm, total reflectance of 95% or more at a wavelength of 460 nm and total reflectance of 92% or more at a wavelength of 800 nm, and with respect to the reflectance attained after a heat treatment of 1 hour at 260°C, total reflectance of 57% is exhibited at a wavelength of 350 nm by a sample having the highest reflectance, total reflectance of 78% is exhibited at a wavelength of 460 nm by a sample having the highest reflectance, and total reflectance of 93% is exhibited at a wavelength of 800 nm by a sample having the highest reflectance. Thus, the reflectance attained after the heat treatment of 1 hour at 260°C is largely degraded in Comparative Examples 3 through 5 than in Examples, and hence, the highly reflective white material of this invention is obviously superior. Moreover, a sample of the reflective material of each of Comparative Examples 6 through 9 where the composition ratios of the resin composition are different exhibits, with respect to the initial reflectance, total reflectance of 80% or more at a wavelength of 350 nm, total reflectance of 95% or more at a wavelength of 460 nm and total reflectance of 92% or more at a wavelength of 800 nm, and with respect to the reflectance attained after a heat treatment of 1 hour at 260°C, total reflectance of 70% is exhibited at a wavelength of 350 nm by a sample having the highest reflectance, total reflectance of 78% is exhibited at a wavelength of 460 nm by a sample having the highest reflectance, and total reflectance of 84% is exhibited at a wavelength of 800 nm by a sample having the highest reflectance. Thus, the reflectance attained after the heat treatment of 1 hour at 260°C is largely degraded in Comparative Examples 6 through 9 than in Examples, and hence, the highly reflective white material of this invention is obviously superior. Furthermore, a sample of the reflective material of Comparative Example 10 where the shape of the alumina used as the filler is changed exhibits, with respect to the initial reflectance, total reflectance of 74% at a wavelength of 350 nm, total reflectance of 86% at a wavelength of 460 nm and total reflectance of 85% at a wavelength of 800 nm, and with respect to the reflectance attained after a heat treatment of 1 hour at 260°C, exhibits total reflectance of 51% at a wavelength of 350 nm, total reflectance of 80% at a wavelength of 460 nm, and total reflectance of 84% at a wavelength of 800 nm. Thus, the reflectance is lower than in Examples even at the initial stage, and the highly reflective white material of the invention is obviously superior. Furthermore, a sample of the reflective material of each of Comparative Examples 11 through 13 where the type of filler to be filled is changed exhibits, with respect to the initial reflectance, total reflectance of 10% or less at a wavelength of 350 nm, total reflectance of 98% or more at a wavelength of 460 nm and total reflectance of 95% or more at a wavelength of 800 nm, and with respect to the reflectance attained after a heat treatment of 1 hour at 260°C, exhibits total reflectance of 10% or less at a wavelength of 350 nm, total reflectance of 92% is exhibited at a wavelength of 460 nm by a sample having the highest reflectance, and total reflectance of 93% is exhibited at a wavelength of 800 nm by a sample having the highest reflectance. Thus, the initial reflectance particularly at the wavelength of 350 nm is largely lower in Comparative Examples 11 through 13 than in Examples, and the highly reflective white material of this invention has high reflectance over a wade wavelength region, and hence is obviously superior.

It is noted that the aforementioned effects may be attained by using 100 or more parts by weight of the spherical alumina in the highly reflective white material in this embodiment, but when the amount of the filler is too large, it is necessary to use a dispersing agent or the like, and a dispersing agent is vulnerable to heat. Therefore, the amount of filler to be included in the highly reflective white material is preferably 300 parts by weight or less.

(Evaluation of Heat Resistance)

A general LED lighting is required of a life time of 40000 hours.
Also, in "Requirements in the performance of white LED luminaires" provided by Japan Luminaires Association, the life time of an LED is defined as a time elapsing before the initial luminous flux is lowered to 70%. Therefore, when a reflective material is subjected to a temperature higher than an actual operating temperature for accelerated aging so as to predict a time elapsing before the reflectance is lowered to 70% by applying Arrhenius plot, a temperature at which a life time of 40000 hours may be guaranteed may be estimated.
Arrhenius plot is an equation representing the relationship between a speed of a chemical reaction and an operating temperature and is represented by equation 1: Equation 1:

$$L = B \cdot \exp(E/kT)$$

wherein L is a life time, B is a constant, E is activation energy, k is Boltzmann's constant and T is an absolute temperature.

When the natural logarithm of this equation is taken, the following equation 2 is obtained: Equation 2:

$$\ln L = (E/k)(1/T) + \ln B$$

This equation 2 is expressed as y = ax + b on a logarithmic graph and may be regarded as a straight line having lnL and 1/T as variables. Therefore, a reflective material is subjected to processing at at least three different temperatures for obtaining times elapsing before the reflectance is lowered to 70% and the times are applied to equation 2. When the resultant equation is a linear equation, a value on the abscissa on which the line crosses 10.4, that is, a natural logarithm of 40000 hours, corresponds to 1/T, and a temperature at which the life time of 40000 hours may be guaranteed may be estimated by obtaining a reciprocal of this value.

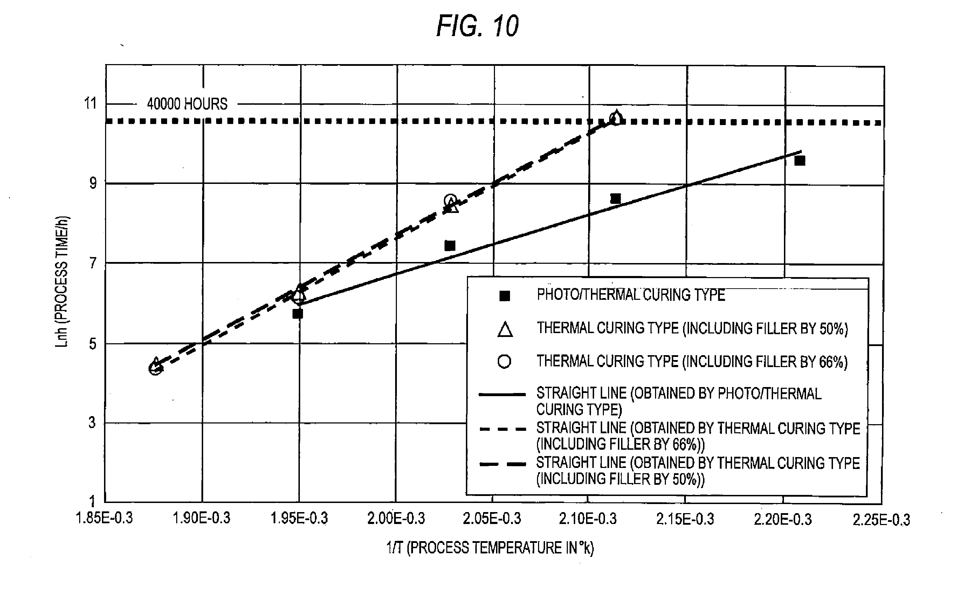

FIG. 10 is a diagram of Arrhenius plot to be employed for estimating a temperature for guaranteeing a life time of 40000 hours of the highly reflective white material of this invention.

Two samples of thermal curing type highly reflective white materials including a filler by 50% and 66% respectively were prepared as examples and a sample of photo/thermal curing type reflective material including a filler by 66% was prepared as a comparative example, and they were subjected to a heat treatment performed at four arbitrary temperatures ranging from 180°C to 260°C, so as to measure change with time of the reflectance. The heat treatment was performed by putting each sample for measuring the reflectance on a vat of stainless steel having a Teflon (registered trademark) sheet with a thickness of 3 mm thereon and placing the vat in a drying oven DX-300 (manufactured by Yamato Scientific Co., Ltd.). FIG. 6 illustrates the thus obtained data plotted in a graph having a natural logarithm of an estimated time elapsing before the reflectance is lowered to 70% as the ordinate and a reciprocal of the absolute temperature of the treatment temperature as the abscissa. As a result, it was found that the temperature at which the life time of 40000 hours is guaranteed was higher in the two samples of the examples of the thermal curing type highly reflective white materials respectively including the filler in the different ratios than in the sample of the comparative example of the photo/thermal curing type reflective material, and thus, the reflective material of this invention is much superior in the heat resistance.

The highly reflective white material of this invention may be used in a reflector for a backlight of a liquid crystal display, a reflector for use in any of various lightings, a reflector included in an LED package or the like.

This application claims the benefit of Japanese Patent application No. 2010-078456 filed on March 30, 2010, Japanese Patent application No. 2010-121097 filed on May 27, 2010, Japanese Patent application No. 2011-022376 filed on February 4, 2011, the entire contents of which are incorporated herein by reference.

**Claims**

1.   A highly reflective white material comprising:

   a mixed resin of an adamantane resin having an acrylic functional group and a silicone resin; and
   a curative agent.

2.   The highly reflective white material according to claim 1, wherein the mixed resin includes, as 100 parts by weight in total, 20 through 90 parts by weight of the adamantane resin having an acrylic functional group and 10 through 80 parts by weight of the silicone resin.

3.   The highly reflective white material according to claim 2, wherein the adamantane resin having an acrylic functional group is 1-adamantyl methacrylate.

4.   The highly reflective white material according to claim 2, wherein the silicone resin is additional reaction type silicone rubber.

5.   The highly reflective white material according to claim 2, wherein the curative agent is a radical photopolymerization initiator.

6.   The highly reflective white material according to claim 5, wherein the radical photopolymerization initiator is an alkylphenone-based photopolymerization initiator.

**7.** An LED package comprising:

a metal lead frame on which a light emitting device is mounted;
a reflector disposed to surround the light emitting device excluding an upper portion thereof; and
the highly reflective white material of claim 1.

**8.** The highly reflective white material according to claim 1, wherein the highly reflective white material is obtained by curing a resin composition for a reflective material, the resin composition being obtained by mixing the mixed resin including, as 100 parts by weight in total, 20 through 50 parts by weight of the adamantane resin having an acrylic functional group and 50 through 80 parts by weight of the silicone resin; the curative agent; and 100 or more parts by weight of alumina in the form of spherical particles.

**9.** The highly reflective white material according to claim 8, wherein the adamantane resin having an acrylic functional group is 1-adamantyl methacrylate.

**10.** The highly reflective white material according to claim 8, wherein the silicone resin is additional reaction type silicone rubber.

**11.** The highly reflective white material according to claim 8, wherein the curative agent is a radical photopolymerization initiator.

**12.** The highly reflective white material according to claim 11, wherein the radical photopolymerization initiator is an alkylphenone-based photopolymerization initiator.

**13.** An LED package comprising:

a metal lead frame on which a light emitting device is mounted;
a reflector disposed to surround the light emitting device excluding an upper portion thereof; and
the highly reflective white material of claim 8.

**14.** The highly reflective white material according to claim 1, wherein the highly reflective white material is obtained by curing a resin composition for a reflective material, the resin composition being obtained by mixing the mixed resin including, as 100 parts by weight in total, 20 through 50 parts by weight of the adamantane resin having an acrylic functional group and 50 through 80 parts by weight of the silicone resin; 1 through 2 parts by weight of a radical thermopolymerization initiator; and 100 or more parts by weight of alumina in the form of spherical particles.

**15.** The highly reflective white material according to claim 14, wherein the adamantane resin having an acrylic functional group is 1-adamantyl methacrylate.

**16.** The highly reflective white material according to claim 14, wherein the silicone resin is additional reaction type silicone rubber.

**17.** The highly reflective white material according to claim 14, wherein the radical thermopolymerization initiator is an organic peroxide-based thermopolymerization initiator.

**18.** An LED package comprising:

a metal lead frame on which a light emitting device is mounted;
a reflector disposed to surround the light emitting device excluding an upper portion thereof; and
the highly reflective white material of claim 14.

# FIG. 1

```
┌─────────────────────────┐
│        WEIGHING         │
└─────────────────────────┘
            │
            ▼
┌─────────────────────────┐
│         MIXING          │
└─────────────────────────┘
            │
            ▼
┌─────────────────────────┐
│        APPLYING         │
└─────────────────────────┘
            │
            ▼
┌─────────────────────────┐
│     PRIMARY CURING      │
└─────────────────────────┘
            │
            ▼
┌─────────────────────────┐
│    SECONDARY CURING     │
└─────────────────────────┘
```

## FIG. 2

## FIG. 3

# FIG. 4

# FIG. 5

## FIG. 6

## FIG. 7

## FIG. 8

## FIG. 9

## FIG. 10

## REFERENCES CITED IN THE DESCRIPTION

**Patent documents cited in the description**

- JP 2010078456 A
- JP 2010121097 A
- JP 2011022376 A